# EUROPEAN PATENT APPLICATION

(11) **EP 0 926 711 A2**
(43) Date of publication of application: **30.06.1999**
(21) Application number: 98310442.3
(22) Date of filing: 18.12.1998
(51) Int. Cl.: H01L 21/28, H01L 21/768, H01L 21/8242

(54) **Gate electrode fabrication method**

(30) Priority: 19.12.1997 US 994274
(71) Applicant: SIEMENS AKTIENGESELLSCHAFT, 80333 München (DE); International Business Machines Corporation, Armonk, N.Y. 10504 (US)
(72) Inventor: Dehm, Christine, 81543 Munich (DE); Srinivasan, Radhika, Mahwah, NJ 97437 (US); Loh, Stephen K., Fishkill, NY 12524 (US)
(74) Representative: Litchfield, Laura Marie

(57) **Abstract**

Methods for forming an integrated circuit, in particular for improving chemical vapor deposition of silicide on gate level interconnects in integrated circuits in order to reduce abnormal oxidation and nucleation of the silicide are disclosed. According to one aspect of the present invention, a method for forming a gate level interconnect in an integrated circuit includes forming a substrate, depositing a layer of gate oxide over the substrate, and depositing a layer of polycrystalline silicon over the gate oxide. A first layer of silicide is formed over the layer of polycrystalline silicon using a first chemical vapor deposition process at a first deposition temperature, and a second layer of silicide is formed over the first layer of silicide using a second chemical vapor deposition process at a second deposition temperature. In one embodiment, the second layer of silicide is formed directly over the first layer of silicide.

## Description

The invention relates generally to a method for fabricating gates for integrated circuits and to the resulting integrated circuit. More particularly, the invention relates to methods and apparatus for preventing abnormal oxidation of silicide films on gates during processing at elevated temperatures and controlling fluorine incorporation in silicide films.

As the demand for integrated circuits, such as dynamic random access memory (DRAM) integrated circuits, increases, the need for efficiently produced integrated circuits is also increasing. Producing integrated circuits in such a way that the integrity of the integrated process may be protected throughout the fabrication process increases the overall throughput of the integrated circuits.

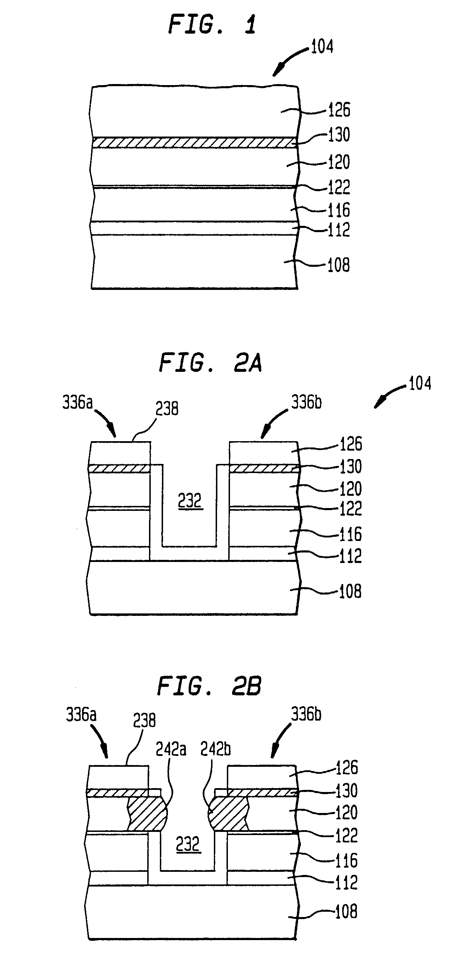

Figure 1 is a diagrammatic representation of a known gate structure. A gate structure 104 is typically included as part of an integrated circuit, *e.g.*, a DRAM integrated circuit, and includes a substrate 108. Substrate 108 is generally formed from silicon, and may also include various other layers associated with the formation of the integrated circuit of which gate structure 104 is a part. Such layers often include oxide layers and conductive layers.

A gate dielectric layer 112 is formed over substrate 108, and is generally an oxide film which lies between substrate 108 and a polycrystalline silicon layer 116. Polycrystalline silicon layer 116, which is often doped, is formed over gate oxide layer 112 to serve as an electrically conductive buffer between a silicide film 120 and gate oxide layer 112. Polycrystalline silicon layer 116, when doped, is generally doped using a dopant such as boron, phosphorous, or arsenic.

Silicide film 120 is generally low in resistance, and may be formed from either tungsten silicide (WSiₓ), cobalt (CoSiₓ), or titanium silicide (TiSiₓ). Silicide film 120 is often formed from tungsten silicide, because of its low resistance and thermal stability. In addition, tungsten silicide also has a low contamination level, as well as good step coverage.

Tungsten silicide film 120 may be deposited using either a chemical vapor deposition (CVD) with silane as a source gas and tungsten hexafluoride as a reactant gas, or a CVD with dichlorosilane as a source gas and tungsten hexafluoride as a reactant gas. Tungsten silicide film 120 may also be deposited by sputtering (PVD). When silicide film 120 is deposited using CVD with dichlorosilane as a source gas and tungsten hexafluoride as a reactant gas, silicide film 120 has a relatively low fluorine content, *e.g.*, less than approximately 10¹⁸ atoms per cubic centimeter. Such a silicide film 120 may show compositional non-uniformities due to poor silicide nucleation on polysilicon layer 116, especially when polysilicon layer 116 is doped with phosphorous or arsenic. Compositional non-uniformities thereby cause a tungsten-rich nucleation layer 122 to form at the interface between silicide film 120 and polycrystalline silicon layer 116. A tungsten-rich nucleation layer 122 may cause high stress values and adhesion problems in gate structure 104.

A nitride layer 126, which is deposited using a low pressure CVD (LPCVD), overlays silicide layer 120,. Nitride layer 126 is generally used to insulate silicide layer 120 from other structural components. When LPCVD nitride deposition occurs at temperatures of greater than approximately 700 degrees Centigrade, an abnormally oxidized silicide film 130 may form near the interface between nitride layer 126 and silicide film 120. Specifically, when tungsten-rich silicides are exposed to oxidizing ambients at temperatures of more than approximately 700 degrees Centigrade, the formation of silicon dioxide and potentially volatile tungsten oxides results. In general, abnormal oxidation may also occur during all subsequent processing steps that occur at temperatures of greater than approximately 700 degrees Centigrade, during which silicide layer 120, or portions of silicide layer 120, are exposed. Such subsequent steps include gate sidewall isolation after gate stack patterning, as will be described with reference to Figures 2a and 2b.

Figure 2a is a diagrammatic representation of the known gate structure of Figure 1 after gate stacks have been defined and sidewall oxide has been added in accordance with prior art. An opening 232 is etched in gate structure 104 to define gate stacks 236. In general, opening 232 is etched down to gate oxide layer 112. A sidewall gate oxide layer 238, which insulates gate stacks 336, is deposited such that sidewall gate oxide layer 238 conforms to gate stacks 236 and substrate 108, as shown.

In some cases, areas of abnormal oxidation form at the interface between silicide film 120 and sidewall gate oxide layer 238. Figure 2b is a diagrammatic representation of the conventional gate structure of Figure 2a after a gate sidewall oxidation process which results in abnormal oxidation in accordance with prior art. Areas of abnormal oxidation 242 form when tungsten silicide in silicide film 120 are exposed to oxidizing ambients at temperatures of greater than approximately 900 degrees Centigrade. Areas of abnormal oxidation 242 may cause electrical shorts in post processing steps, as will be appreciated by those skilled in the art.

As previously mentioned, rather than being deposited using CVD with dichlorosilane as a source gas and tungsten hexafluoride as a reactant gas, a silicide film may be deposited using a chemical vapor deposition (CVD) with silane as a source gas and tungsten hexafluoride as a reactant gas. In general, silicide deposited using silane as a source gas have a wider process window than silicide deposited using dichlorosilane as a source gas. That is, silicide deposited using silane as a source gas have more efficient nucleation, a more uniform composition, and are less prone to abnormal oxidation. Therefore, silicide deposited using silane as a source gas is able to withstand higher temperatures, *e.g.*, temperatures of up to approximately 1100 degrees Centigrade, before abnormal oxidation may occur. Silicide deposited using silane as a source gas, however, has a high fluorine level, *e.g.*, a fluorine level of greater than approximately 10²⁰ atoms per cubic centimeter, whereas silicide deposited using dichlorosilane as a source gas have a lower fluorine concentration, *e.g.*, a fluorine level of less than approximately 10¹⁸ atoms per cubic centimeter. When large levels of fluorine diffuse during processing at elevated temperatures into an underlying gate oxide layer, degradation of the gate oxide layer may occur. Lower levels of fluorine, such as those in the range of approximately 10¹⁸ to approximately 10²⁰ cm⁻³ may be advantageous due to passivation of dangling bonds and increased resistance to radiation and hot electrons.

According to a first aspect of the invention there is provided a method for forming a gate level interconnect in an integrated circuit comprising:
forming a substrate;
depositing a layer of gate oxide over the substrate;
depositing a layer of polycrystalline silicon over the gate oxide;
forming a first layer of silicide over the layer of polycrystalline silicon using a first chemical vapor deposition process at a first deposition temperature; and forming a second layer of silicide over the first layer of silicide using a second chemical vapor deposition process at a second deposition temperature.

According to a second aspect of the invention there is provided a gate level interconnect in an integrated circuit comprising:
a substrate;
a layer of gate oxide disposed over the substrate;
a layer of polycrystalline silicon disposed over the layer of gate oxide;
a first layer of silicide disposed over the layer of polycrystalline silicon; and a second layer of silicide disposed over the first layer of silicide, wherein the first layer of silicide and the second layer of silicide are distinct, the first layer of silicide and the second layer of silicide being formed using different processes.

According to a third aspect of the invention there is provided an integrated circuit comprising:
a substrate;
a layer of gate oxide disposed over the substrate;
a layer of polycrystalline silicon disposed over the gate oxide layer; and
a layered silicide structure including a plurality of silicide layers, the plurality of silicide layers including a first silicide layer being disposed over the layer of polycrystalline silicon, wherein the first silicide layer is formed using a first deposition process at a first deposition temperature, the plurality of silicide layers further including a second silicide layer disposed over the first silicide layer, wherein the second silicide layer is formed using a second deposition process at a second deposition temperature.

According to a fourth aspect of the invention there is provided a method for controlling an overall level fluorine concentration in a gate level interconnect, the gate level interconnect being included in an integrated circuit, the method comprising:
forming a substrate;
depositing a layer of gate oxide over the substrate;
depositing a layer of polycrystalline silicon over the gate oxide;
forming a first layer of silicide over the layer of polycrystalline silicon using a first chemical vapor deposition process, the first layer of silicide having a first concentration of fluorine; and
forming a second layer of silicide over the first layer of silicide using a second chemical vapor deposition process, the second layer of silicide having a second concentration of fluorine, wherein the first layer of silicide and the second layer of silicide cooperate to control the overall level of fluorine concentration in the gate level interconnect.

Thus method for improving chemical vapor deposition of silicide on gate level interconnects in integrated circuits are disclosed. These methods may reduce abnormal oxidation, tungsten-rich nucleation, and nucleation of the silicide.

In an advantageous embodiment, the second layer of silicide is formed directly over the first layer of silicide. The step of forming a gate level interconnect may include the step of forming the first layer of silicide by providing silane as a first source gas and providing tungsten hexafluoride as a first reactant gas. The second layer of silicide may be formed using dichlorosilane as a second source gas and tungsten hexafluoride as a second reactant gas. The first deposition temperature is advantageously in the range of approximately 350 degrees Centigrade to approximately 550 degrees Centigrade, and while the second deposition temperature is advantageously in the range of approximately 500 degrees Centigrade to approximately 700 degrees Centigrade.

The first silicide layer and the second silicide layer may be tungsten silicide layers. The polycrystalline silicon layer may be a doped polycrystalline silicon layer.

For a better understanding of the present invention, and to show how it may be brought into effect, reference will now be made, by way of example, to the accompanying drawings, in which:

Figure 1 is a diagrammatic representation of a gate structure with tungsten silicide as a gate level interconnect layer in accordance with prior art.

Figure 2a is a diagrammatic representation of the gate structure of Figure 1 after gate stacks have been defined and sidewall oxide has been added in accordance with prior art.

Figure 2b is a diagrammatic representation of the gate structure of Figure 2a after a gate sidewall oxidation process in accordance with prior art.

Figure 3a is a diagrammatic representation of a gate structure with a first layer of silicide deposited thereon in accordance with an embodiment of the present invention.

Figure 3b is a diagrammatic representation of the gate structure of Figure 3a with a second layer of silicide deposited thereon in accordance with an embodiment of the present invention.

Figure 3c is a diagrammatic representation of the gate structure of Figure 3b on which a layer of nitride is deposited using a low pressure chemical vapor deposition process in accordance with an embodiment of the present invention.

Figure 3d is a diagrammatic representation of the gate structure of Figure 3c with defined gate stacks after a gate sidewall oxidation process in accordance with an embodiment of the present invention.

Figure 4 is a process flow diagram which illustrates the steps associated with forming a gate level interconnect structure in accordance with an embodiment of the present invention.

The present invention will now be described in detail with reference to embodiments thereof as illustrated in the accompanying drawings. In the following description, numerous specific details are set forth in order to provide a thorough understanding of the present invention. It will be apparent, however, to one of skill in the art, that the present invention may be practiced without some or all of these specific details. In other instances, well known process steps and/or structures have not been described in detail in order to not unnecessarily obscure the present invention.

In accordance with a method of the present invention, the overall WSiₓ layer may be deposited using two separate processes. This method helps to alleviate problems associated with the formation of a tungsten rich nucleation layer at the interface between a doped polycrystalline silicon layer and an overall silicide (WSiₓ ) layer in a gate structure, as well as to reduce abnormal oxidation in the overall WSiₓ layer. That is, a first layer of the overall layer of WSiₓ is deposited using one chemical vapor deposition (CVD) process, while a second layer of the overall layer of WSiₓ is deposited using a second CVD process. The first layer of WSiₓ, *i.e.*, the portion of the overall WSiₓ layer which interfaces with the doped polycrystalline silicon layer, is deposited using a CVD process which fosters nucleation on the doped polycrystalline silicon layer, preventing a tungsten-rich nucleation layer, thereby improving stability and adhesion. The second layer of WSiₓ is deposited using a CVD process which reduces the fluorine level in the second layer of WSiₓ.

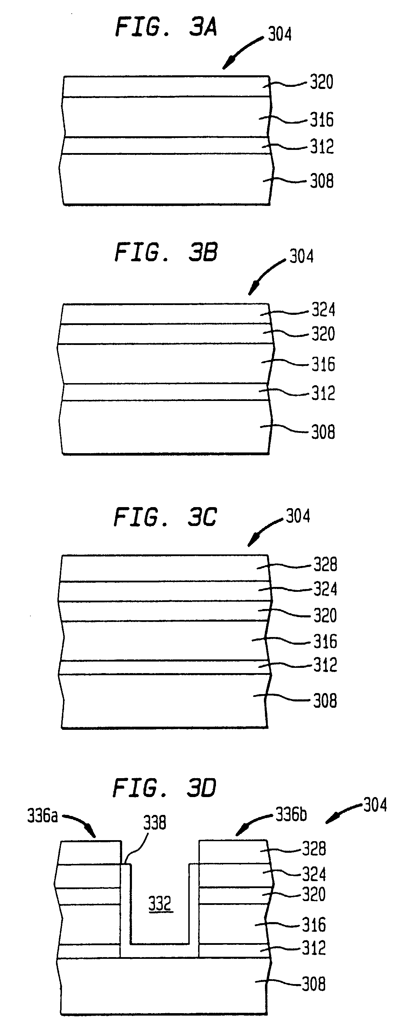

Figure 3a is a diagrammatic representation of a gate structure with a first layer of silicide deposited thereon in accordance with an embodiment of the present invention. A gate structure 304 includes a substrate 308 on which a gate oxide layer 312, or film, is formed. Substrate 308 may be a substrate of an integrated circuit chip, such as a dynamic random access memory (DRAM) chip. In general, substrate 308 may be made of silicon, and may further include various layers, including conductive layers and oxide layers. Substrate 308 may typically also include various junction regions. A polycrystalline silicon layer 316 is deposited over gate oxide layer 312. In general, polycrystalline silicon layer 316 is doped with a dopant such as boron, phosphorous, or arsenic.

A first WSiₓ layer 320 is deposited over polycrystalline silicon layer 316. In the described embodiment, first WSiₓ layer 320 is formed using a CVD process in a temperature range of between approximately 350 degrees Centigrade and approximately 550 degrees Centigrade. The CVD process may use silane (SiH₄) as a source gas and tungsten hexafluoride (WF₆) as a reactant gas. Such a CVD process nucleates relatively efficiently on polycrystalline silicon layer 316, and introduces low levels of fluorine to saturate dangling bonds at the interface between gate oxide layer 312 and polycrystalline silicon layer 316, thereby improving the resistance of gate structure 304 to radiation and hot electrons, without causing thickening within gate oxide layer 312. The low levels of fluorine, as for example levels of approximately 10¹⁸ to approximately 10²⁰ cm⁻³, improve the yield and reliability of gate structure 304 without shifting device parameters and degrading gate oxide layer 312. In general, the fluorine content in first WSiₓ layer 320 may be controlled by controlling the thickness of WSiₓ layer 320.

The thickness of each layer in gate structure 304 may generally be widely varied depending upon a number of different factors. Such factors may include, but are not limited to, the particular technology in which gate structure 304 is to be implemented. For example, layer thickness will generally be smaller for 0.175 micron DRAM generation than for 0.25 micron DRAM generation. In one embodiment, gate oxide layer 312 may have a thickness in the range of approximately 40 Angstroms to approximately 100 Angstroms, *e.g.*, approximately 60 Angstroms to approximately 65 Angstroms. In such an embodiment, polycrystalline silicon layer 316 may have a thickness in the range of approximately 500 Angstroms to approximately 1000 Angstroms, while first WSiₓ layer 320 has a thickness in the range of approximately 100 Angstroms to approximately 200 Angstroms.

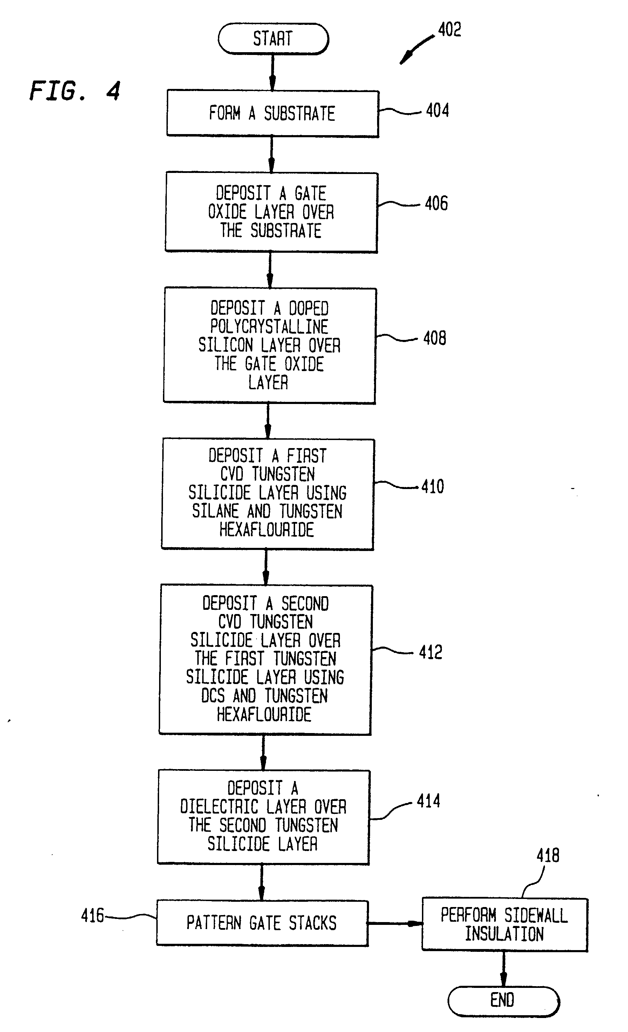

With reference to Figure 3b, gate structure 304 of Figure 3a, with a second layer of WSiₓ deposited thereon, will be described in accordance with an embodiment of the present invention. A second layer of WSiₓ 324 is deposited, or grown, over first layer of WSiₓ 320. In the described embodiment, second layer of WSiₓ 324 is deposited using a CVD process performed with dichlorosilane (DCS) as a silicon source and tungsten hexaflouride as a reactant gas, as will be described below with reference to Figure 4.

As was the case for the thickness of first WSiₓ layer 320, the thickness of second WSiₓ layer 324 may depend on a variety of different factors. The thickness of second WSiₓ layer 324 may be determined by the resultant resistance, *i.e.*, the overall thickness of WSiₓ. For example, the overall combined thickness of first WSiₓ layer 320 and second WSiₓ layer 324 may be in the range of approximately 500 Angstroms to approximately 1000 Angstroms. Accordingly, if first WSiₓ layer 320 has a thickness in the range of approximately 100 Angstroms to approximately 200 Angstroms, then second WSiₓ layer 324 may have a corresponding thickness in the range of approximately 400 Angstroms to approximately 800 Angstroms.

A nitride layer 328, is deposited over second WSiₓ layer 324, as shown in Figure 3c. In one embodiment, nitride layer 328 may be deposited using a low pressure chemical vapor deposition (LPCVD) nitride deposition process. Nitride layer 328 essentially forms a cap over second WSiₓ layer 324, and is often used to insulate the gates within gate structure 304. In addition, nitride layer 328 may be patterned, or otherwise masked, to define individual gates.

When nitride layer 328 is deposited over second WSiₓ layer 324, which is deposited using a CVD process performed with DCS as a silicon source and tungsten hexaflouride as a reactant gas, as mentioned above with respect to Figure 3b, second WSiₓ layer 324 does not oxidize. That is, the creation of silicon dioxide (SiO₂) and tungsten oxides such as WSiₓO_{y} or WO₃ is reduced.

Figure 3d is a diagrammatic representation of gate structure 304 of Figure 3c with defined gate stacks after a gate sidewall oxidation process in accordance with an embodiment of the present invention. An opening 332 is etched in gate structure 304 to define gate stacks 336. In general, opening 332 is etched down to near gate oxide layer 312. A sidewall gate oxide layer 338 is deposited such that sidewall gate oxide layer 338 conforms to gate stacks 336 and substrate 308, as shown. As will be appreciated by those skilled in the art, sidewall gate oxide layer 338 serves to prevent leakage in gate stacks 336. Gate oxide layer 338 is an insulator that protects second WSiₓ layer 324, first WSiₓ layer 320, and polycrystalline silicon layer 316 from other structural components.

Referring next to Figure 4, one embodiment of a process for forming a gate level interconnect structure will be described in accordance with the present invention. As previously described, a gate level interconnect may generally be formed in substantially any integrated circuit device, as for example a submicron memory device such as a DRAM. The process of forming a gate level interconnect 402 begins at step 404 in which a substrate is formed. The substrate may include any number of different layers including, but not limited to, silicon layers and conducting layers. Once a substrate is formed, a gate oxide layer is deposited over the substrate in step 406.

After the gate oxide layer is deposited in step 406, process flow proceeds to step 408 in which a polycrystalline silicon layer is deposited over the gate oxide layer. In general, the polycrystalline silicon layer is doped using phosphorous or arsenic, although it should be appreciated that the polycrystalline silicon layer may be doped using any suitable dopant.

A first CVD WSiₓ layer is deposited over the polycrystalline silicon layer in step 410. In the described embodiment, the first CVD WSiₓ layer is deposited using silane as a source gas and tungsten hexaflouride as a reactant gas at a process temperature that is in the range of approximately 350 degrees Centigrade to approximately 550 degrees Centigrade. More specifically, the first CVD WSiₓ layer may be deposited at a temperature which is in the range of approximately 400 degrees Centigrade to approximately 450 degrees centigrade.

A CVD WSiₓ layer deposited over a doped polycrystalline silicon layer using silane as a source gas and tungsten hexafluoride as a reactant gas generally nucleates more efficiently than a CVD WSiₓ layer deposited using other chemistries, such as chemistries involving the use of dichlorosilane as a source gas. In one embodiment, the fluorine concentration in the first CVD WSiₓ layer is in the range of approximately 10¹⁹ to approximately 10²¹ cm⁻³.

In step 412, a second CVD WSiₓ layer is deposited directly over the first WSiₓ layer using DCS as a source gas and tungsten hexafluoride as a reactant gas. In general, the process temperature associated with depositing the second CVD WSiₓ layer is higher than the process temperature associated with depositing the first CVD WSiₓ layer. The second CVD WSiₓ layer is generally deposited at temperatures which are greater than approximately 600 degrees Centigrade. By way of example, the process temperature associated with depositing the second CVD WSiₓ layer may be in the range of approximately 500 degrees Centigrade to approximately 600 degrees Centigrade.

By depositing the second CVD WSiₓ layer using DCS and tungsten hexafluoride, the WSiₓ adhesion, step coverage, stress, and fluorine concentration are improved over the adhesion, step coverage, stress, and fluorine concentration of WSiₓ deposited using silane and tungsten hexafluoride. Improving these properties of the WSiₓ serves to increase the overall performance of the integrated circuit which includes the gate level interconnect structure.

A nitride layer is deposited over the second WSiₓ layer in step 414. Typically, the nitride layer is deposited using a low pressure chemical vapor deposition (LPCVD) which may occur at a process temperature in the range of approximately 700 degrees Centigrade to approximately 800 degrees Centigrade. The nitride layer essentially forms a nitride cap which may be used to mask, or otherwise define, gate conductor stacks in step 416. In other words, gate conductor stacks are patterned in step 416. Once the gate conductor stacks are patterned and a sidewall insulation process is performed in step 418, the process of forming a gate level interconnect structure is completed. It should be appreciated after the gate level interconnect structure is created, various other processing steps, *e.g.*, etching steps, may generally be implemented to actually create gate conductor stacks, as previously mentioned.

Although only a few embodiments of the present invention have been described, it should be understood that the present invention may be embodied in many other specific forms without departing from the spirit or the scope of the present invention. By way of example, the present invention has been described as using CVD to deposit WSiₓ layers over a substrate. However, the present invention may also generally be implemented for use with other silicide layers including, but not limited to, titanium silicide layers. WSiₓ layers are often used instead of titanium silicide layers due to the fact that WSiₓ is, in general, considered to be more robust than titanium silicide, which may exhibit problems such as agglomeration at elevated temperatures.

While the use of "neighboring" layers of silicide which are formed using different CVD processes has been described in terms of implementation in gate interconnect structures, the use of neighboring layers of silicide may also be used for a variety of other structures. In other words, separate silicide layers, *e.g.*, layers where one layer directly overlays another, may be implemented within substantially any integrated circuit which includes portions with silicide, without departing from the spirit or the scope of the present invention.

Further, although the layered silicide structure in a gate interconnect structure has been described in terms of including two distinct silicide layers, the silicide structure may generally include multiple silicide layers formed using separate processes, *e.g.*, separate CVD processes. Such CVD processes may use any suitable chemistries and process temperatures. Therefore, the present examples are to be considered as illustrative and not restrictive, and the invention is not to be limited to the details given herein, but may be modified within the scope of the appended claims.

## Claims

1. A method for forming a gate level interconnect in an integrated circuit comprising:
forming a substrate;
depositing a layer of gate oxide over the substrate;
depositing a layer of polycrystalline silicon over the gate oxide;
forming a first layer of silicide over the layer of polycrystalline silicon using a first chemical vapor deposition process at a first deposition temperature; and forming a second layer of silicide over the first layer of silicide using a second chemical vapor deposition process at a second deposition temperature.

2. A method for forming a gate level interconnect as recited in claim 1 wherein the second layer of silicide is formed directly over the first layer of silicide.

3. A method for forming a gate level interconnect as recited in claims 1 or 2 wherein:
forming the first layer of silicide includes providing a silane as a first source gas and providing a hexafluoride as a first reactant gas; and
forming the second layer of silicide includes providing a dichlorosilane as a second source gas and providing a hexafluoride as a second reactant gas.

4. A method for forming a gate level interconnect as recited in any preceding claim wherein the first and the second layers of silicide are tungsten-based, and first and second reactant gases used in the first and second chemical vapour deposition processes, respectively, include tungsten hexafluoride.

5. A method for forming a gate level interconnect as recited in any preceding claim wherein the first deposition temperature at which the first layer of silicide is deposited is in the range of approximately 350 degrees Centigrade to approximately 550 degrees 1Centigrade.

6. A method for forming a gate level interconnect as recited in any preceding claim wherein the second deposition temperature at which the second layer of silicide is deposited is at least as high as the first deposition temperature.

7. A method for forming a gate level interconnect as recited in any preceding claim wherein the second deposition temperature at which the second layer of silicide is deposited is in the range of approximately 500 degrees Centigrade to approximately 700 degrees Centigrade.

8. A method for forming a gate level interconnect as recited in any preceding claim further including doping the layer of polycrystalline silicon.

9. A method for forming a gate level interconnect as recited in claim 1 wherein the gate level interconnect is formed in a dynamic random access memory integrated circuit.

10. A gate level interconnect in an integrated circuit comprising:
a substrate;
a layer of gate oxide disposed over the substrate;
a layer of polycrystalline silicon disposed over the layer of gate oxide;
a first layer of silicide disposed over the layer of polycrystalline silicon; and a second layer of silicide disposed over the first layer of silicide, wherein the first layer of silicide and the second layer of silicide are distinct, the first layer of silicide and the second layer of silicide being formed using different processes.

11. A gate level interconnect as recited in claim 10 wherein the second layer of silicide is disposed directly over the first layer of silicide.

12. A gate level interconnect as recited in claims 10 or 11 wherein the first layer of silicide and the second layer of silicide are tungsten-based.

13. A gate level interconnect as recited in one of claims 10 - 12 wherein the polycrystalline silicon layer is a doped polycrystalline silicon layer.

14. A gate level interconnect as recited in one of claims 10 - 13 wherein the gate level interconnect is formed in a dynamic random access memory integrated circuit.

15. An integrated circuit comprising:
a substrate;
a layer of gate oxide disposed over the substrate;
a layer of polycrystalline silicon disposed over the gate oxide layer; and
a layered silicide structure including a plurality of silicide layers, the plurality of silicide layers including a first silicide layer being disposed over the layer of polycrystalline silicon, wherein the first silicide layer is formed using a first deposition process at a first deposition temperature, the plurality of silicide layers further including a second silicide layer disposed over the first silicide layer, wherein the second silicide layer is formed using a second deposition process at a second deposition temperature.

16. An integrated circuit as recited in claim 15 wherein the second layer of silicide is disposed directly over the first layer of silicide.

17. An integrated circuit as recited in claims 15 or 16 wherein the layer of polycrystalline silicon is doped.

18. An integrated circuit as recited in one of claims 15 - 17 wherein the first silicide layer and the second silicide layer are tungsten silicide layers.

19. An integrated circuit as recited in one of claims 15 - 18 wherein the integrated circuit is a dynamic random access memory.

20. A method for controlling an overall level fluorine concentration in a gate level interconnect, the gate level interconnect being included in an integrated circuit, the method comprising:
forming a substrate;
depositing a layer of gate oxide over the substrate;
depositing a layer of polycrystalline silicon over the gate oxide;
forming a first layer of silicide over the layer of polycrystalline silicon using a first chemical vapor deposition process, the first layer of silicide having a first concentration of fluorine; and
forming a second layer of silicide over the first layer of silicide using a second chemical vapor deposition process, the second layer of silicide having a second concentration of fluorine, wherein the first layer of silicide and the second layer of silicide cooperate to control the overall level of fluorine concentration in the gate level interconnect.
